# EUROPÄISCHE PATENTSCHRIFT

(11) **EP 3 065 177 B1**
(45) Veröffentlichungstag und Bekanntmachung des Hinweises auf die Patenterteilung: **26.01.2022**
(21) Anmeldenummer: 16000369.5
(22) Anmeldetag: 15.02.2016
(51) Int. Cl.: H01L 31/0687, H01L 31/0224, H01L 27/142

(54) **SOLARZELLENVORRICHTUNG**
SOLAR CELL DEVICE
DISPOSITIF DE CELLULES SOLAIRES

(30) Priorität: 02.03.2015 DE 102015002513
(43) Veröffentlichungstag der Anmeldung: 07.09.2016
(73) Patentinhaber: AZUR SPACE Solar Power GmbH, 74072 Heilbronn (DE)
(72) Erfinder: Meusel, Matthias, 74076 Heilbronn (DE); Köstler, Wolfgang, 74074 Heilbronn (DE); Fuhrmann, Daniel, 74081 Heilbronn (DE); Lauermann, Thomas, 12557 Berlin (DE)
(74) Vertreter: Koch Müller Patentanwaltsgesellschaft mbH

(56) Entgegenhaltungen:
- EP-A1- 1 008 188
- DE-A1- 10 056 214
- DE-A1-102011 115 340
- GB-A- 2 346 010
- STROBL, G. ET AL: "Development and Qualification Status of European Triple Junction Solar Cells for Space Applications", PROCEEDINGS OF THE 19TH EUROPEAN PHOTOVOLTAIC SOLAR ENERGY CONFERENCE, 7. Juni 2004 (2004-06-07), - 11. Juni 2004 (2004-06-11), Seiten 3614-3617, XP040511254, Paris, France ISBN: 978-3-936338-15-7

## Beschreibung

Die Erfindung betrifft eine Solarzellenvorrichtung.

Aus der EP 1 008 188 A1, der US 6 600 100 A2, der EP 1 443 566 A1, der DE 10 2011 115 340 A1, der GB 2 346 010, der DE 100 56 214 A1 und der US 7 449 630 A2 sind unterschiedliche Konzepte für Solarzellenvorrichtung mit einer Mehrfachsolarzelle und eine Schutzdiodenstruktur bekannt. Ferner sind aus der DE 10 2004 055 225 A1 und der DE 10 2004 023 856 A1 und insbesondere aus G.F.X.Strobl et al, Evolution of Fully European Triple GaAs Solar Cell, Proc. "Seventh European Space Power Conference," Stresa, Italy, 9-13 May 2005 (ESA SP-589, May 2005) weitere gattungsbildende Solarzellenvorrichtungen bekannt. Insbesondere weist die EP 1 008 188 A1 an der Oberseite des Solarzellenstapels nur die bekannte Fensterschicht aus p+dotierte AIGaAs unmittelbar aufliegend auf der GaInP-Teitzelle auf, während auf der Schutzstruktur unmittelbar Metall auf die n++dotierte Teilschicht der Tunneldiode ausgebildet ist.

Vor diesem Hintergrund besteht die Aufgabe der Erfindung darin, eine Vorrichtung anzugeben, die den Stand der Technik weiterbildet.

Die Aufgabe wird durch eine Solarzellenvorrichtung mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine Solarzellenvorrichtung mit einer Mehrfachsolarzelle und einer Schutzdiodenstruktur bereitgestellt, wobei die Mehrfachsolarzelle und die Schutzdiodenstruktur eine gemeinsame Rückseitenfläche und durch einen Mesa-Graben getrennte Vorderseiten aufweisen, und die gemeinsame Rückseitenfläche eine elektrisch leitfähige Schicht umfasst und das Licht durch die Vorderseite in die Mehrfachsolarzelle eintritt, und wobei die Mehrfachsolarzelle einen Stapel aus drei oder mehr Solarzellen umfasst, und eine der Vorderseite am nächsten angeordnete obere Solarzelle und eine der Rückseite am nächsten angeordnete untere Solarzelle aufweist, und jede Solarzelle einen np-Übergang umfasst und zwischen benachbarten Solarzellen eine Tunneldiode angeordnet ist, und die Anzahl der Halbleiterschichten bei der Schutzdiodenstruktur kleiner als die Anzahl der Halbleiterschichten bei der Mehrfachsolarzelle ist, jedoch die Abfolge der Halbleiterschichten bei der Schutzdiodenstruktur der Abfolge der Halbleiterschichten der Mehrfachsolarzelle entspricht, wobei bei der Schutzdiodenstruktur wenigstens eine obere Schutzdiode und eine der Rückseite am nächsten angeordnete untere Schutzdiode ausgebildet ist und zwischen benachbarten Schutzdiode eine Tunneldiode angeordnet ist, und die Anzahl der np-Übergänge in der Schutzdiodenstruktur wenigstens um eins kleiner als die Anzahl der np-Übergänge der Mehrfachsolarzelle ist, auf der Vorderseite der Mehrfachsolarzelle und der Schutzdiodenstruktur eine Anschlusskontaktstruktur enthaltend eine oder mehrere Metallschichten und eine unterhalb der Anschlusskontaktstruktur aus mehreren Halbleiterschichten bestehend elektrisch leitfähige Kontaktschicht ausgebildet ist, und die Kontaktschicht eine Tunneldiode umfasst.

Es sei angemerkt, dass der Mesa-Graben ein zwischen dem Schichtstapel der Schutzdiodenstruktur und der stapelförmigen Mehrfachsolarzelle vollständig ausgebildet ist, so dass die beiden Stapel an deren Oberseite vollständig getrennt sind und nur an der Unterseite eine gemeinsam ausgebildete zusammenhängende Schicht aufweisen. Auch sei angemerkt, dass die Mehrfachsolarzelle und die Schutzdiodenstruktur als np Übergänge ausgebildet sind, d.h. die n-Schicht ist von der Vorderseite aus gesehen oberhalb der p-Schicht abgeordnet.

Es versteht sich, der Schichtstapel der Schutzdiodenstruktur an der Vorderseite zwar die gleiche Anschlusskontaktstruktur mit insbesondere Metallschichten wie die Mehrfachsolarzelle aufweist, jedoch unterhalb der Anschlusskontaktstruktur auf der Schutzdiodenstruktur mehrere Schichten im Vergleich zu der Mehrfachsolarzelle wegätzt sind. Hierdurch weist die Schutzdiodenstruktur weniger Halbleiterschichten auf. Auch ist bevorzugt, dass Solarzellenvorrichtung einen Halbleiterwafer, besonders bevorzugt einen Germaniumwafer, umfasst. Im Allgemeinen nimmt die Mehrfachsolarzelle den weit überwiegenden Teil, vorzugsweise über 90 % der Wafer Fläche ein, während die Schutzdiodenstruktur an einer der Ecken des Wafers angeordnet ist. In einer Draufsicht auf die Wafer Oberfläche sind die beiden Strukturen neben einander angeordnet und durch den Mesa-Graben getrennt.

Des Weiteren versteht sich, dass die Schutzdiodenstruktur und die Mehrfachsolarzelle überwiegend Schichten aus III-V Halbleitermaterialien aufweisen. Hierbei weisen die einzelnen Solarzellen der Mehrfachsolarzelle unterschiedliche Bandlücken auf, wobei die der Vorderseite am nächsten angeordnete obere Solarzelle eine größere Bandlücke als eine mittlere Solarzelle und die mittlere Solarzelle eine größere Bandlücke als die der Rückseite am nächsten angeordnete untere Solarzelle aufweist. Hierdurch findet der Lichteinfall immer durch die obere Solarzelle statt. Das nicht von der oberen Solarzelle absorbierte Spektrum fällt in die weiteren Solarzellen ein. Es sei darauf hingewiesen, dass der Solarzellenstapel und die Schutzstruktur vorzugsweise monolithisch integriert sind. In einer alternativen Ausführungsform beinhaltet der jeweilige Stapel eine Halbleiterbondfläche. In einer alternativen Ausführungsform weist der Solarzellenstapel mehr als drei Solarzellen auf. Bevorzugt weist der Solarzellenstapel vier oder fünf oder sechs Solarzellen auf.

Ein Vorteil der Anordnung ist es, dass mit der Ausbildung der Metallkontakte auf einer Tunneldiode insbesondere bei der Schutzdiodenstruktur die Zuverlässigkeit und die Langzeitstabilität der Schutzdiodenstruktur erhöht wird. Ferner werden für die Ausbildung der Schutzdiodenstruktur keine zusätzlichen Halbleiter oder Metallschichten aufgebracht, sondern es werden die Halbleiter und die Metallschichten der Mehrfachzelle zum vorderseitigen Anschluss der Schutzdiodenstruktur verwendet. Anders ausgedrückt weisen die Schutzdiodenstruktur und die Mehrfachzelle die gleiche Anschlusskontaktstruktur auf. Eine Charakterisierung und Qualifizierung von zwei unterschiedlichen Kontaktsystemen erübrigt sich.

Untersuchungen haben gezeigt, dass sich mit der Ausbildung der Tunneldiode eine bessere Ausbeute bzw. eine robusterer Herstellungsprozess ergibt. Ferner lässt sich der Produktionsprozess flexibel einsetzen, d.h. ausgehend von der Mehrfachsolarzelle lässt sich mit wenigen zusätzlichen Prozessschritten die Schutzdiodenstruktur unter Verwendung der gleichen Anschlusskontaktstruktur herstellen.

Andere Untersuchungen haben gezeigt, dass in überraschender Weise die Einführung einer zusätzlichen Tunneldiode der Spannungsabfall auch bei höheren Stromdichten in der Schutzdiodenstruktur nur unwesentlich beeinflusst wird und insbesondere das Durchschaltverhalten der Schutzdiodenstruktur sich nicht verändert. Auch zeigte sich, dass die Einführung von zusätzlichen Schichten zur Ausbildung der Tunneldiode die Ausbeute nicht verringert sondern erhöht.

In einer Ausführungsform umfasst die elektrisch leitfähige Schicht an der Rückseite eine oder mehrere Metallschichten und / oder eine oder mehrere auf den Metallschichten angeordnete Halbleiterschichten. Insbesondere bei der Verwendung von Germaniumsubstrat Wafern ist es vorteilhaft eine Halbleiterschicht aus Germanium vorzusehen, d.h. die Mesa-Ätzung zur Ausbildung des Mesa-Grabens stoppt in dem Germaniumsubstrat.

In einer Weiterbildung ist zwischen Anschlusskontaktstruktur und der Tunneldiode eine p-dotierte Halbleiterschicht ausgebildet. Vorzugsweise umfasst die p-dotierte Halbleiterschicht eine Verbindung von GalnP oder GaAs, und die Kontaktschicht an der Vorderseite ein oder mehrere Metallschichten.

Untersuchungen haben gezeigt, dass es vorteilhaft ist, wenn die Anschlusskontaktstruktur eine Schicht aus einer AuZn Legierung und/oder eine Schicht bestehend aus einer Verbindung aus Ag und/oder eine Schicht bestehend aus einer Verbindung aus Au und/oder eine Schicht bestehend aus einer Zn-Legierung umfasst. Hierdurch lässt sich insbesondere auf einer p-dotierten Halbleiterschicht eine niederohmige Verbindung erzielen. Anders ausgedrückt ist es vorteilhaft, die Metallschicht stoffschlüssig auf der p-dotierten Halbleiterschicht auszubilden.

In einer Ausführungsform werden die Tunneldioden aus wenigstens einer negativ dotierten und wenigstens einer positiv dotierten Schicht gebildet, wobei die negative Dotierung durch die Elemente Si und/oder Te und/oder Se realisiert ist und/oder die positive Dotierung durch die Elemente C und/oder Zn und/oder Mg realisiert ist. Vorzugsweise ist die Dotierstoffkonzentration der Schichten größer als 1 × 10e18 cm-3, höchst vorzugsweise größer als 3 x 10e18 cm-3.

In einer anderen Weiterbildung ist eine Tunneldiode zwischen der obere Solarzelle und der Anschlusskontaktstruktur ausgebildet. Vorzugsweise besteht die Tunneldiode aus wenigstens zwei übereinander liegenden Schichten bestehend aus einer GaAs Verbindung, wobei zumindest eine der Schichten oder beide Schichten einen Aluminium-Gehalt zwischen 1% und 40% aufweist. Höchst vorzugsweise beträgt der Al-Gehalt in eine der Schichten oder beiden Schichten zwischen 5% und 20%.

In einer anderen Weiterbildung weist die Mehrfachsolarzelle eine mittlere Solarzelle auf. Bevorzugst ist, dass die obere Solarzelle GaInP und die mittlere Solarzelle GaAs oder GalnAs und die untere Solarzelle Ge umfasst.

In einer bevorzugten Ausführungsform umfasst die Mehrfachsolarzelle mehr als drei Solarzellen. Es versteht sich, dass mit einer zunehmenden Anzahl von Solarzellen mit unterschiedlichen Bandlücken sich die Bandlücken der jeweiligen Solarzellen einfacher aufeinander abstimmen lassen und sich der Wirkungsgrad der Anordnung erhöhen lässt.

In einer anderen Weiterbildung grenzt die Anschlusskontaktstruktur der Schutzdiode zumindest teilweise oder vollständig unmittelbar an eine p- dotierte Halbleiterschicht an, wobei vorzugsweise die p-dotierte Halbleiterschicht aus einer Verbindung aus GaInP oder AlGaAs oder GaAs oder GaInAs besteht. In einer alternativen Ausführungsform grenzt die Anschlusskontaktstruktur der Mehrfachsolarzelle zumindest teilweise oder vollständig unmittelbar an eine positiv dotierte Halbleiterschicht, wobei die Halbleiterschicht aus einer Verbindung aus GaAs besteht. Anders ausgedrückt, die Anschlusskontaktstruktur bildet wenigstens teilweise oder vollständig eine stoffschlüssige Verbindung mit der p-dotierten Halbleiterschicht aus.

Erfindungsgemäß weist die Anschlusskontaktstruktur der Schutzdiode und der Mehrfachsolarzelle eine identische Schichtfolge auf. Es versteht sich, dass die beiden Schichtstapel als gemeinsam zusammenhängende Schichten vorzugsweise epitaktisch gewachsen sind und erst nach dem wachsen der Schichten die beiden Stapel mittels einer Mesa-Ätzung getrennt sind.

In einer bevorzugten Weiterbildung umfassen die Schutzdiodenstruktur und die Mehrfachsolarzelle einen Halbleiterspiegel, wobei die Schichten des Halbleiterspiegels eine Dotierung größer als 1E17/cm³ aufweisen. Mittels der hohen Dotierung weist der Halbleiterspiegel einen geringeren elektrischen Widerstand auf. Vorzugsweise ist der Hableiterspiegel zwischen zwei benachbarten Solarzellen ausgebildet.

In einer Weiterbildung ist die Vorderseite der Schutzdiode nicht mit der Rückseite der Mehrfachsolarzelle elektrisch leitfähig verbunden. Hingegen ist die Schutzdiodenstruktur mit der Mehrfachsolarzelle eines weiteren Wafers verschaltet, d.h. die Schutzstruktur des vorliegenden Wafers schützt die Solarzellenstruktur des nächsten, vorzugsweise unmittelbar benachbarten Wafer. Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine Querschnittsansicht auf eine erste erfindungsgemäße Ausführungsform,
- Figur 2: eine detaillierte Ausführungsform der Querschnittsansicht dargestellt in der Figur 1.

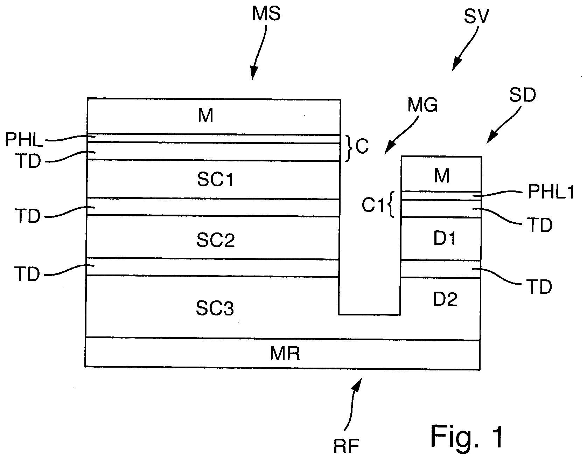

Die Abbildung der Figur 1 zeigt eine Querschnittsansicht auf eine erste erfindungsgemäße Ausführungsform einer Solarzellenvorrichtung SV mit einer Mehrfachsolarzelle MS und einer Schutzdiodenstruktur SD, wobei die Mehrfachsolarzelle MS und die Schutzdiodenstruktur SD eine gemeinsame Rückseitenfläche RF und durch einen Mesa-Graben MG getrennte Vorderseiten aufweisen. Die gemeinsame Rückseitenfläche RF umfasst eine elektrisch leitfähige Schicht MR. Die Mehrfachsolarzelle MS umfasst einen Stapel aus mehreren Solarzellen SC1, SC2, SC3 mit einer der Vorderseite am nächsten angeordneten oberen Solarzelle SC1 und einer mittleren Solarzelle SC2 und eine der Rückseite am nächsten angeordnete unteren Solarzelle SC3. Jede Solarzelle SC1, SC2, SC3 umfasst einen nicht dargestellten np-Übergang. Zwischen benachbarten Solarzellen SC1, SC2 und SC2, SC3 ist jeweils eine Tunneldiode TD angeordnet ist.

Zwar ist die Anzahl der Halbleiterschichten bei der Schutzdiodenstruktur SD kleiner als die Anzahl der Halbleiterschichten bei der Mehrfachsolarzelle MS, jedoch ist die Abfolge der verbliebenen Halbleiterschichten bei der Schutzdiodenstruktur SD identisch zu der Abfolge der Halbleiterschichten der Mehrfachsolarzelle MS. Die Schutzdiodenstruktur SD umfasst eine obere Schutzdiode D1 und eine der Rückseite am nächsten angeordnete untere Schutzdiode D2. Zwischen den beiden Schutzdiode D1 und D2 ist eine Tunneldiode TD angeordnet ist.

Es zeigt sich, dass die Anzahl der np-Übergänge in der Schutzdiodenstruktur SD um eins kleiner ist als die Anzahl der np-Übergänge der Mehrfachsolarzelle MS.

Auf der Vorderseite der Mehrfachsolarzelle MS und der Schutzdiodenstruktur SD ist eine Anschlusskontaktstruktur M aus mehreren nicht dargestellten Metallschichten ausgebildet. Unterhalb der Anschlusskontaktstruktur M ist bei der Mehrfachsolarzelle MS eine aus mehreren nicht im Einzelnen dargestellten Halbleiterschichten bestehend elektrisch leitfähige Kontaktschicht C ausgebildet. Die mehreren Halbleiterschichten umfassen eine Tunneldiode TD. Zwischen der Anschlusskontaktstruktur M und der Tunneldiode TD ist eine p-dotierte Halbleiterschicht PHL als Teil der Kontaktschicht C ausgebildet.

Unterhalb der Anschlusskontaktstruktur M ist bei der Schutzdiodenstruktur SD eine aus mehreren nicht im Einzelnen dargestellten Halbleiterschichten bestehend elektrisch leitfähige Kontaktschicht C1 ausgebildet. Die mehreren Halbleiterschichten umfassen eine Tunneldiode TD. Zwischen der Anschlusskontaktstruktur M und der Tunneldiode TD ist eine p-dotierte Halbleiterschicht PHL1 als Teil der Kontaktschicht C1 ausgebildet.

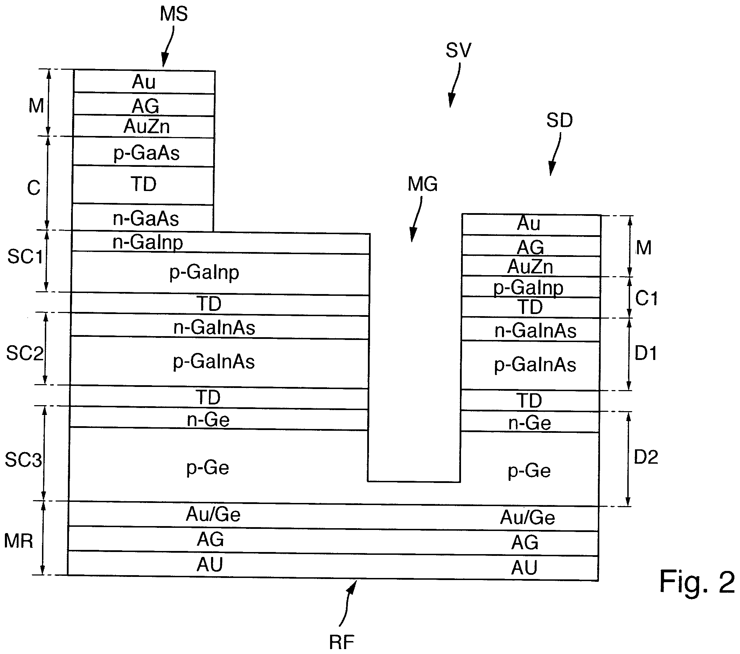

In der Abbildung der Figur 2 ist eine detaillierte Ausführungsform der Querschnittsansicht, dargestellt in der Figur 1, gezeigt. Im Folgenden werden nur die Unterschiede zu der Abbildung der Figur 1 erläutert.

Die Anschlusskontaktstruktur M besteht aus einer aufliegenden Gold Schicht und einer darunterliegenden Schicht aus Silber und einer unter der Silberschicht liegenden Schicht aus einer AuZn Legierung. Unter der AuZn-Schicht ist bei der Mehrfachsolarzelle MS die p-dotierte Halbleiterschicht PHL bestehend aus einer GaAs Verbindung ausgebildet und bei der Schutzdiodenstruktur SD die p-dotierte Halbleiterschicht PHL1 bestehend aus einer p-GaInP Verbindung ausgebildet. Unterhalb der Tunneldiode TD liegt bei der Mehrfachsolarzelle MS eine zu der Kontaktschicht C zugehörige n-dotierte GaAs Schicht, während bei der Schutzdiodenstruktur SD die unterliegende n-dotierte n-GaInAs Schicht bereits zu der oberen Schutzdiode zugehörig ist, d.h. nicht mehr von der Kontaktschicht C1 umfasst wird.

Unterhalb der Kontaktschicht C weist der Solarzellenstapel MS die obere Solarzelle SC1 mit einer n-dotierten GaInP Emitterschicht und einer p-dotierten GaInP Basisschicht auf. Unterhalb der TD weist die mittlere Solarzelle SC2 eine n-dotierte InGaAs Emitterschicht und eine p-dotierte InGaAs Basisschicht auf. Unterhalb der TD weist die untere Solarzelle SC3 eine n-dotierte Ge Emitterschicht und eine p-dotierte Ge Basisschicht auf.

Unterhalb der Kontaktschicht C1 weist die Schutzdiodenstruktur SD unterhalb der Tunneldiode TD die obere Schutzdiode D1 mit einer n-dotierten InGaAs Schicht und einer p-dotierten InGaAs Schicht auf. Unterhalb der TD weist die untere Schutzdiode D2 eine n-dotierte Ge Schicht und eine p-dotierte Ge Schicht auf. Die p-dotierte Ge Basisschicht stellt eine für den Solarzellenstapel MS und die Schutzdiodenstruktur SD gemeinsame Schicht dar.

Unterhalb der p-dotierte Ge Basisschicht ist für den Rückseitenanschlusskontakt MR eine Gold-Germanium-Schicht AU/GE ausgebildet. Unterhalb der Gold-Germanium-Schicht AU/GE ist eine AG-Schicht und unterhalb der AG-Schicht eine AU-Schicht ausgebildet.

Es sei angemerkt, dass die Ausführungsform auch eine n-fach Solarzelle SCn - nicht dargestellt - übertragen lässt. Hierbei ist n eine natürliche Zahl größer als drei. Die Anzahl N der Schutzdioden D1, D2, DN ist wenigstens um ein kleiner als die Anzahl der Solarzellen n, d.h. es gilt für die Diodenanzahl N= n-1

## Patentansprüche

1. Solarzellenvorrichtung (SV) mit einer Mehrfachsolarzelle (MS) und einer Schutzdiodenstruktur (SD), wobei
die Mehrfachsolarzelle (MS) und die Schutzdiodenstruktur (SD) eine gemeinsame Rückseitenfläche (RF) und durch einen Mesa-Graben (MG) getrennte Vorderseiten aufweisen, und
die gemeinsame Rückseitenfläche (RF) eine elektrisch leitfähige Schicht umfasst und
das Licht durch die Vorderseite in die Mehrfachsolarzelle (MS) eintritt, und wobei
die Mehrfachsolarzelle (MS) einen Stapel aus drei oder mehr Solarzellen (SC1, SC2, SC3) umfasst, und eine der Vorderseite am nächsten angeordnete obere Solarzelle (SC1), eine der Rückseite am nächsten angeordnete untere Solarzelle (SC3) und eine mittlere Solarelle (SC2) aufweist, und jede Solarzelle (SC1, SC2, SC3) einen np-Übergang umfasst und zwischen benachbarten Solarzellen eine Tunneldiode (TD) angeordnet ist, und
die Anzahl der Halbleiterschichten der Schutzdiodenstruktur (SD) kleiner als die Anzahl der Halbleiterschichten der Mehrfachsolarzelle (MS) ist, jedoch die Abfolge der verbliebenen Halbleiterschichten bei der Schutzdiodenstruktur (SD) identisch mit der Abfolge der Halbleiterschichten der Mehrfachsolarzelle (MS) ist, wobei bei der Schutzdiodenstruktur (SD) wenigstens eine obere Schutzdiode (D1) und eine der Rückseite am nächsten angeordnete untere Schutzdiode (D2) ausgebildet ist und zwischen benachbarten Schutzdiode (D1, D2) eine Tunneldiode (TD) angeordnet ist, und
die Anzahl der np-Übergänge in der Schutzdiodenstruktur (SD) wenigstens um eins kleiner als die Anzahl der np-Übergänge der Mehrfachsolarzelle (MS) ist, und
auf der Vorderseite der Mehrfachsolarzelle (MS) und der Schutzdiodenstruktur (SD) jeweils eine Anschlusskontaktstruktur (M) enthaltend eine oder mehrere Metallschichten und eine unterhalb der Anschlusskontaktstruktur (M) und oberhalb der Vorderseite der Mehrfachsolarzelle (MS)
und oberhalb der Vorderseite der Schutzdiodenstruktur (SD) angeordnete, aus mehreren Halbleiterschichten bestehende, elektrisch leitfähige Kontaktschicht (C, C1) ausgebildet ist, und die mehreren Halbleiterschichten der oberhalb der Vorderseite der Schutzdiodenstruktur (SD) angeordneten Kontaktschicht (C1) eine weitere Tunneldiode (TD) umfassen,
**dadurch gekennzeichnet, dass**
die mehreren Halbleiterschichten der oberhalb der Vorderseite der Mehrfachsolarzelle (MS) angeordnete Kontaktschicht (C) eine weitere Tunneldiode (TD) umfassen.

2. Solarzellenvorrichtung (SV) nach Anspruch 1, **dadurch gekennzeichnet, dass** zwischen der Anschlusskontaktstruktur (M) und der weiteren Tunneldiode (TD) eine p-dotierte Halbleiterschicht (PHL, PHL1) als Teil der Kontaktschicht (C, C1) ausgebildet ist.

3. Solarzellenvorrichtung (SV) nach Anspruch 2, **dadurch gekennzeichnet, dass** die p-dotierte Halbleiterschicht eine Verbindung von GaInP oder GaAs umfasst.

4. Solarzellenvorrichtung (SV) nach einem der vorangehenden Ansprüche, **dadurch gekennzeichnet, dass** die Anschlusskontaktstruktur (M) eine Schicht aus einer AuZn Legierung und/oder
eine Schicht bestehend aus einer Verbindung aus Ag und/oder
eine Schicht bestehend aus einer Verbindung aus Au und/oder
eine Schicht bestehend aus einer Zn-Legierung umfasst.

5. Solarzellenvorrichtung (SV) nach einem der vorangehenden Ansprüche, **dadurch gekennzeichnet, dass** die Tunneldioden (TD) aus wenigstens einer negativ dotierten und einer positiv dotierten Schicht gebildet werden, wobei die negative Dotierung durch die Elemente Si oder Te oder Se realisiert ist und die Dotierstoffkonzentration der Schichten größer als 1 x 10¹⁸ cm⁻³ beträgt .

6. Solarzellenvorrichtung nach einem der vorgehenden Ansprüche, **dadurch gekennzeichnet, dass** die Tunneldioden (TD) aus wenigstens einer negativ dotierten und einer positiv dotierten Schicht gebildet werden, wobei die positive Dotierung durch die Elemente C oder Zn oder Mg realisiert ist und die Dotierstoffkonzentration der Schichten größer als 1 x 10¹⁸ cm⁻³ beträgt.

7. Solarzellenvorrichtung (SV) nach einem der vorangehenden Ansprüche, **dadurch gekennzeichnet, dass** oos die weitere Tunneldiode (TD) der oberhalb der Mehrfachsolarzelle (MS) angeordneten Kontaktschicht (C) aus wenigstens zwei übereinander liegenden Schichten bestehend aus einer GaAs Verbindung ausgebildet ist und/oder dest eine der beiden Schichten einen Aluminium-Gehalt zwischen 1% und 40% aufweist.

8. Solarzellenvorrichtung (SV) nach einem oder mehreren der vorangehenden Ansprüche, **dadurch gekennzeichnet, dass** die Mehrfachsolarzelle (MS) eine mittlere Solarzelle (SC2) aufweist und die obere Solarzelle (SC1) GaInP und die mittlere Solarzelle (SC2) GaAs oder GaInAs und die untere Solarzelle (SC3) Ge umfasst.

9. Solarzellenvorrichtung (SV) nach einem oder mehreren der vorangehenden Ansprüche, **dadurch gekennzeichnet, dass** die Mehrfachsolarzelle (MS) mehr als drei Solarzellen (SC1, SC2; SC3, SCn) umfasst.

10. Solarzellenvorrichtung (SV) nach einem oder mehreren der vorangehenden Ansprüche, **dadurch gekennzeichnet, dass** die Anschlusskontaktstruktur der Schutzdiode (M) zumindest teilweise unmittelbar an eine positiv dotierte Halbleiterschicht angrenzt, wobei die Halbleiterschicht aus einer Verbindung aus GaInP oder AIGaAs besteht oder dass die Anschlusskontaktstruktur (M) der Mehrfachsolarzelle (MS) zumindest teilweise unmittelbar an eine positiv dotierte Halbleiterschicht angrenzt, wobei die Halbleiterschicht aus einer Verbindung aus GaAs besteht.

11. Solarzellenvorrichtung (SV) nach einem oder mehreren der vorangehenden Ansprüche, **dadurch gekennzeichnet, dass** die Anschlusskontaktstruktur (M) der Schutzdiode und der Mehrfachsolarzelle (MS) eine identische Schichtfolge aufweisen.

12. Solarzellenvorrichtung (SV) nach einem oder mehreren der vorangehenden Ansprüche, **dadurch gekennzeichnet, dass** die Schutzdiodenstruktur (SD) und die Mehrfachsolarzelle (MS) einen Halbleiterspiegel umfassen und die Schichten des Halbleiterspiegels eine Dotierung gröBer als 1E17/cm³ aufweisen.

13. Solarzellenvorrichtung (SV) nach einem oder mehreren der vorangehenden Ansprüche, **dadurch gekennzeichnet, dass** die Vorderseite der Schutzdiode nicht mit der Rückseite der Mehrfachsolarzelle (MS) elektrisch leitfähig verbunden ist.

## Claims

1. Solar cell device (SV) with a multiple solar cell (MS) and a protective diode structure (SD), wherein
the multiple solar cell (MS) and the protective diode structure (SD) have a common rear side surface (RF) and front sides separated by a mesa trench (MG), and
the common rear side surface (RF) comprises an electrically conductive layer and
the light enters through the front side into the multiple solar cell (MS), and wherein
the multiple solar cell (MS) comprises a stack of three or more solar cells (SC1, SC2, SC3) and has an upper solar cell (SC1) arranged closest to the front side, a lower solar cell (SC3) arranged closest to the rear side and a middle solar cell (SC2) and each solar cell (SC1, SC2, SC3) has an n-p transition and a tunnel diode (TD) is arranged between adjacent solar cells, and
the number of semiconductor layers of the protective diode structure (SD) is less than the number of semiconductor layers of the multiple solar cell (MS), but the sequence of the remaining semiconductor layers in the protective diode structure (SD) is identical with the sequence of the semiconductor layers of the multiple solar cell (MS), wherein in the case of the protective diode structure (SD) at least one upper protective diode (D1) and lower protective diode (D2), which is arranged closest to the rear side, are formed and a tunnel diode (TD) is arranged between adjacent protective diodes (D1, D2), and
the number of n-p transitions in the protective diode structure (SD) is less at least by one than the number of n-p transitions of the multiple solar cell (MS), and
formed on the front side of the multiple solar cell (MS) and the protective diode structure (SD) is a respective connecting contact structure (M) containing one or more metal layers and an electrically conductive contact layer (C, C1), which is arranged below the connecting contact structure (M) and above the front side of the multiple solar cell (MS) and above the front side of the protective diode structure (SD) and consists of several semiconductor layers, and the several semiconductor layers of the contact layer (C1) arranged above the front side of the protective diode structure (SD) comprise a further tunnel diode (TD),
**characterised in that**
the several semiconductor layers of the contact layer (C) arranged above the front side of the multiple solar cell (MS) comprise a further tunnel diode (TD).

2. Solar cell device (SV) according to claim 1, **characterised in that** a p-doped semiconductor layer (PHL, PHL1) as part of the contact layer (C, C1) is formed between the connecting contact structure (M) and the further tunnel diode (TD).

3. Solar cell device (SV) according to claim 2, **characterised in that** the p-doped semiconductor layer comprises a compound of GaInP or GaAs.

4. Solar cell device (SV) according to any one of the preceding claims, **characterised in that** the connecting contact structure (M) comprises a layer of an AuZn alloy and/or a layer consisting of a compound of Ag and/or a layer consisting of a compound of Au and/or a layer consisting of a Zn alloy.

5. Solar cell device (SV) according to any one of the preceding claims, **characterised in that** the tunnel diodes (TD) are formed from at least one negatively doped layer and positively doped layer, wherein the negative doping is realised by the elements Si or Te or Se and the doping substance concentration of the layers is greater 1 x 10¹⁸ cm⁻³.

6. Solar cell device (SV) according to any one of the preceding claims, **characterised in that** the tunnel diodes (TD) are formed from at least one negatively doped layer and positively doped layer, wherein the positive doping is realised by the elements C or Zn or Mg and the doping substance concentration of the layers is greater than 1 x 10¹⁸ cm⁻³.

7. Solar cell device (SV) according to any one of the preceding claims, **characterised in that** the further tunnel diode (TD) of the contact layer (C) arranged above the multiple solar cell (MS) is formed from at least two layers which lie one above the other and consist of a GaAs compound and/or at least one of the two layers has an aluminium content between 1% and 40%.

8. Solar cell device (SV) according to one or more of the preceding claims, **characterised in that** the multiple solar cell (MS) has a middle solar cell (SC2) and the upper solar cell (SC1) comprises GaInP and the middle solar cell (SC2) comprises GaAs or GaInAs and the solar cell (SC3) comprises Ge.

9. Solar cell device (SV) according to one or more of the preceding claims, **characterised in that** the multiple solar cell (MS) comprises more than three solar cells (SC1, SC2; SC3, SCn).

10. Solar cell device (SV) according to one or more of the preceding claims, **characterised in that** the connecting contact structure of the protective diode (M) at least partly directly adjoins a positively doped semiconductor layer, wherein the semiconductor layer consists of a compound of GaInP or AIGaAs or the connecting contact structure (M) of the multiple solar cell (MS) at least partly directly joins a positively doped semiconductor layer, wherein the semiconductor layer consists of a compound of GaAs.

11. Solar cell device (SV) according to one or more of the preceding claims, **characterised in that** the connecting contact structure (M) of the protective diode and the multiple solar cell (MS) have an identical layer sequence.

12. Solar cell device (SV) according to one or more of the preceding claims, **characterised in that** the protective diode structure (SD) and the multiple solar cell (MS) comprise a semiconductor mirror and the layers of the semiconductor mirror have a doping greater than 1E17/cm³.

13. Solar cell device (SV) according to one or more of the preceding claims, **characterised in that** the front side of the protective diode is not electrically conductively connected with the rear side of the multiple solar cell (MS).

## Revendications

1. Dispositif de cellules solaires (SV) avec une cellule solaire multiple (MS) et une structure de diodes de protection (SD), dans lequel
la cellule solaire multiple (MS) et la structure de diodes de protection (SD) présentent une face arrière (RF) commune et des faces avant séparées par une tranchée mesa (MG), et
la lumière entrant à travers la face avant dans la cellule solaire multiple (MS), et dans lequel
la cellule solaire multiple (MS) comprend une pile de trois cellules solaires (SC1, SC2, SC3) ou davantage, et présente une cellule solaire supérieure (SC1) disposée au plus près de la face avant, une cellule solaire inférieure (SC3) disposée au plus près de la face arrière et une cellule solaire médiane (SC2), et chaque cellule solaire (SC1, SC2, SC3) comprend une jonction np et une diode tunnel (TD) est disposée entre les cellules solaires voisines, et
le nombre de couches semi-conductrices de la structure de diodes de protection (SD) est inférieur au nombre de couches semi-conductrices de la cellule solaire multiple (MS), cependant la succession des couches semi-conductrices restantes sur la structure de diodes de protection (SD) est identique à la succession des couches semi-conductrices de la cellule solaire multiple (MS), au moins une diode de protection supérieure (D1) et une diode de protection inférieure (D2) disposée au plus près de la face arrière étant formées dans la structure de diodes de protection (SD) et une diode tunnel (TD) étant disposée entre les diodes de protection (D1, D2) voisines, et
le nombre de jonctions np dans la structure de diodes de protection (SD) est inférieur d'au moins un au nombre de jonctions np dans la cellule solaire multiple (MS), et
sur la face avant de la cellule solaire multiple (MS) et de la structure de diodes de protection (SD) est formée respectivement une structure de contact de raccordement (M) contenant une ou plusieurs couches métalliques et une couche de contact électro-conductrice (C, C1) constituée de plusieurs couches semi-conductrice, disposée au-dessous de la structure de contact de raccordement (M) et au-dessus de la face avant de la cellule solaire multiple (MS) et au-dessus de la face avant de la structure de diodes de protection (SD), et les multiples couches semi-conductrices de la couche de contact (C1) disposée au-dessus de la face avant de la structure de diodes de protection (SD) comprennent une diode tunnel (TD) supplémentaire,
**caractérisé en ce que**
les multiples couches semi-conductrices de la couche de contact (C) disposée au-dessus de la face avant de la cellule solaire multiple (MS) comprennent une diode tunnel (TD) supplémentaire.

2. Dispositif de cellules solaires (SV) selon la revendication 1, **caractérisé en ce qu'**entre la structure de contact de raccordement (M) et la diode tunnel (TD) supplémentaire est formée une couche semi-conductrice dopée p (PHL, PHL1) faisant partie de la couche de contact (C, C1).

3. Dispositif de cellules solaires (SV) selon la revendication 2, **caractérisé en ce que** la couche semi-conductrice dopée p (PHL, PHL1) comprend une liaison de GaInP ou GaAs.

4. Dispositif de cellules solaires (SV) selon une des revendications précédentes, **caractérisé en ce que** la structure de contact de raccordement (M) comprend une couche d'un alliage AuZn et/ou une couche constituée d'une liaison d'Ag et/ou une couche constituée d'une liaison d'Au et/ou une couche constituée d'un alliage de Zn.

5. Dispositif de cellules solaires (SV) selon une des revendications précédentes, **caractérisé en ce que** les diodes tunnels (TD) sont formées d'au moins une couche dopée négativement et une couche dopée positivement, dans lequel le dopage négatif est réalisé par les éléments Si ou Te ou Se et la concentration de dopant des couches est supérieure à 1 x 10¹⁸ cm⁻³.

6. Dispositif de cellules solaires (SV) selon une des revendications précédentes, **caractérisé en ce que** les diodes tunnels (TD) sont formées d'au moins une couche dopée négativement et une couche dopée positivement, dans lequel le dopage positif est réalisé par les éléments C ou Zn ou Mg et la concentration de dopant des couches est supérieure à 1 x 10¹⁸ cm⁻³.

7. Dispositif de cellules solaires (SV) selon une des revendications précédentes, **caractérisé en ce que** la diode tunnel (TD) supplémentaire de la couche de contact (C) disposée au-dessus de la cellule solaire multiple (MS) est formée d'au moins deux couches superposées constituées d'une liaison GaAs et/ou qu'au moins une des deux couches présente une teneur en aluminium de 1% à 40%.

8. Dispositif de cellules solaires (SV) selon une ou plusieurs des revendications précédentes, **caractérisé en ce que** la cellule solaire multiple (MS) présente une cellule solaire médiane (SC2) et que la cellule solaire supérieure (SC1) comprend du GaInP et la cellule solaire médiane (SC2) du GaAs ou du GaInAs et la cellule solaire inférieure (SC3) du Ge.

9. Dispositif de cellules solaires (SV) selon une ou plusieurs des revendications précédentes, **caractérisé en ce que** la cellule solaire multiple (MS) comprend plus de trois cellules solaires (SC1, SC2, SC3, SCn).

10. Dispositif de cellules solaires (SV) selon une ou plusieurs des revendications précédentes, **caractérisé en ce que** la structure de contact de raccordement de la diode de protection (M) jouxte au moins partiellement immédiatement une couche semi-conductrice dopée positivement, la couche semi-conductrice étant constituée d'une liaison de GaInP ou d'AlGaAs ou que la structure de contact de raccordement (M) de la cellule solaire multiple (MS) jouxte au moins partiellement immédiatement une couche semi-conductrice dopée positivement, la couche semi-conductrice étant constituée d'une liaison de GaAs.

11. Dispositif de cellules solaires (SV) selon une ou plusieurs des revendications précédentes, **caractérisé en ce que** la structure de contact de raccordement (M) de la diode de protection et la cellule solaire multiple (MS) présentent une succession de couches identique.

12. Dispositif de cellules solaires (SV) selon une ou plusieurs des revendications précédentes, **caractérisé en ce que** la structure de diodes de protection (SD) et la cellule solaire multiple (MS) comprennent un miroir semi-conducteur et que les couches du miroir semi-conducteur présentent un dopage supérieur à 1E17/cm³.

13. Dispositif de cellules solaires (SV) selon une ou plusieurs des revendications précédentes, **caractérisé en ce que** la face avant de la diode de protection n'est pas reliée de manière électro-conductrice avec la face arrière de la cellule solaire multiple (MS).
